# EUROPEAN PATENT APPLICATION

(11) **EP 2 790 229 A1**
(43) Date of publication of application: **15.10.2014**
(21) Application number: 12856509.0
(22) Date of filing: 05.12.2012
(51) Int. Cl.: H01L 31/04

(54) **SOLAR CELL AND SOLAR CELL MANUFACTURING METHOD**

(30) Priority: 08.12.2011 JP 2011268787
(71) Applicant: Bridgestone Corporation, Tokyo 104-8340 (JP)
(72) Inventor: SHIINO, Osamu, Kodaira-shi Tokyo 187-8531 (JP); OKINO, Kenji, Kodaira-shi Tokyo 187-8531 (JP); YOSHIKAWA, Masato, Kodaira-shi Tokyo 187-8531 (JP); MIYANO, Mari, Kodaira-shi Tokyo 187-8531 (JP); NAKAMURA, Satoshi, Kodaira-shi Tokyo 187-8531 (JP); YAMAMOTO, Yukiko, Kodaira-shi Tokyo 187-8531 (JP)
(74) Representative: Oxley, Robin John George
(86) International application number: PCT/JP2012/081547
(87) International publication number: WO 2013/084954

(57) **Abstract**

A solar cell (1) according to the invention is formed by stacking a first electrode layer (1C), a semiconductor layer (1A), and a second electrode layer (1D). The first electrode layer (1C) is placed on a light-irradiated surface side of the semiconductor layer (1A). The first electrode layer (1C) and the semiconductor layer (1A) are joined together with a Schottky junction interface in between. The second electrode layer (1D) is placed on an opposite side of the semiconductor layer (1A) from the light-irradiated surface. The second electrode layer (1D) and the semiconductor layer (1A) are joined together in ohmic contact with each other. The first electrode layer (1C) includes a visible light absorbing material.

## Description

### [Technical Field]

The present invention relates to a solar cell and a method of manufacturing the same.

### [Background Art]

Schottky solar cell structures have heretofore been known (Patent Document 1 and Non-patent Document 1).

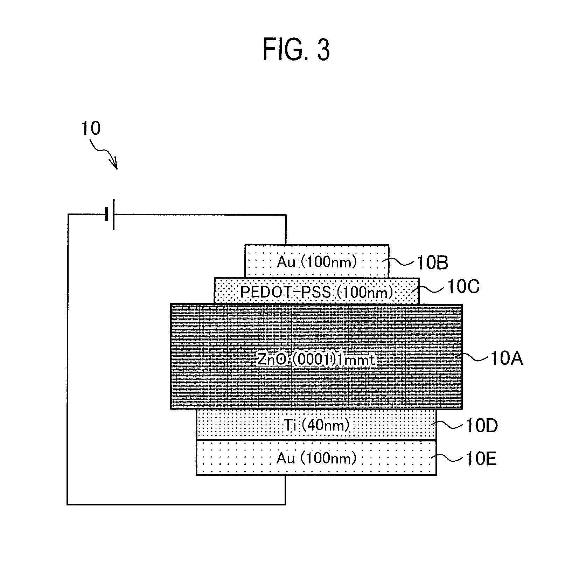

For example, a structure of a Schottky solar cell 10 shown in Fig. 3 has been known. Specifically, the solar cell 10 is formed by stacking a semiconductor layer 10A, a front electrode layer 10B, a first electrode layer 10C, a second electrode layer 10D and a back electrode layer 10E, as shown in Fig. 3.

In the example shown in Fig. 3, the semiconductor layer 10A is formed from a 1-mmt-thick ZnO substrate (in (0001) orientation), and the front electrode 10B is formed from Au with a thickness of 100 nm.

In addition, the first electrode layer 10C is formed from a 100-nm-thick PEDOT-PSS (a conductive polymer made by H. C. Starck GmbH).

The second electrode layer 10D is a metallic electrode layer for ohmic contact which is formed from Ti with a thickness of 40 nm. The back electrode layer 10E is formed from Au with a thickness of 100 nm.

It should be noted that the first electrode layer 10C and the semiconductor layer 10A are joined together with a Schottky junction interface in between, and the second electrode layer 10D and the semiconductor layer 10A are joined together by ohmic contact.

The solar cell 10 is formed in a way that: once incident light hits the semiconductor layer 10A via the front electrode layer 10B and the first electrode layer 10C, electrons in a valence band jump to a conduction band in the semiconductor layer 10A, and photocarriers (electrons and holes) are thereby generated; photocarrier separation occurs due to built-in potential difference (diffusion potential difference) which exists in the semiconductor layer 10A near the Schottky junction interface; and thereby photovoltaic effects take place.

It should be noted that when the light energy of the incident light is less than the bandgap between the conduction band and the valence band in the semiconductor layer 10A, no such photovoltaic effects take place because: in the semiconductor layer 10A, no electrons in the valence band can jump to the conduction band; and the semiconductor layer 10A accordingly cannot absorb the incident light.

### [Citation List]

### [Patent Literature]

[PTL 1] Japanese Patent Application Publication No. 2010-219399

### [Non Patent Literature]

[NPL 1] APPLIED PHYSICS LETTERS 93, 12309(2008)

### [Summary of Invention]

In this respect, in the structure of the Schottky solar electron 10 shown in Fig. 3, the light energy of visible light is less than the bandgap between the conduction band and the valence band in the semiconductor layer 10A formed from the ZnO substrate. For this reason, no photovoltaic effects take place when the visible light is incident.

As a result, the Schottky solar electron 10 shown in Fig. 3 has a problem of poor power generation efficiency with the sunlight including a large amount of the visible light.

The present invention has been made with the foregoing problem taken into consideration. An object of the present invention is to provide a Schottky solar cell having fine power generation efficiency with the sunlight including a large amount of the visible light, and a method of manufacturing the same.

A first feature of the present invention is summarized as a solar cell including a first electrode layer, a semiconductor layer and a second electrode layer which are stacked, in which the first electrode layer is placed on a light-irradiated surface side of the semiconductor layer, the first electrode layer and the semiconductor layer are joined together with a Schottky junction interface in between, the second electrode layer is placed on an opposite side of the semiconductor layer from the light-irradiated surface, the second electrode layer and the semiconductor layer are joined together in ohmic contact with each other, and the first electrode layer includes a visible light absorbing material.

### [Brief Description of Drawings]

[Fig. 1]

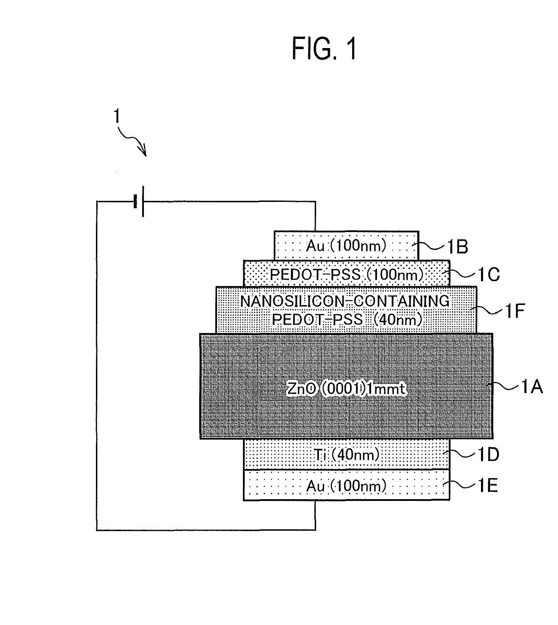

   Fig. 1 is a diagram showing a structure of a solar cell of a first embodiment of the present invention.
[Fig. 2]

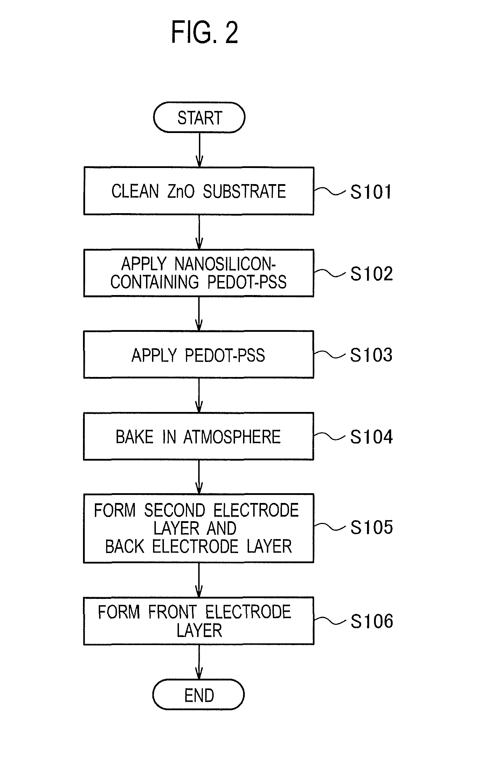

   Fig. 2 is a flowchart showing an example of a method of manufacturing a solar cell of the first embodiment of the present invention.
[Fig. 3]
   Fig. 3 is a diagram showing a structure of a solar cell of a conventional technique.

### [Description of Embodiments]

### [First Embodiment of Present Invention]

Referring to Fig. 1, descriptions will be provided for a solar cell 1 and a method of manufacturing the solar cell 1 of a first embodiment of the present invention.

Specifically, as shown in Fig. 1, the solar cell 10 of the embodiment is formed by stacking a semiconductor layer 1A, a front electrode layer 1B, a first electrode layer 1C/1F, a second electrode layer 1D and a back electrode layer 1E.

The semiconductor layer 1A is formed from a 1-mmt-thick ZnO substrate (in (0001) orientation), for example.

The front electrode 1B is formed from Au with a thickness of 100 nm, for example. The back electrode layer 1E is formed from Au with a thickness of 100 nm, for example.

The second electrode layer 1D is a metallic electrode layer for ohmic contact, which is formed from Ti with a thickness of 40 nm, for example. To put it specifically, the second electrode layer 1D is placed on an opposite side of the semiconductor layer 10A from the light-irradiated surface, and is formed in ohmic contact with the semiconductor layer 1A.

The first electrode layer 1C/1F is placed on a light-irradiated surface side of the semiconductor layer 10A, and is formed with a Schottky barrier between the first electrode layer 1C/1F and the semiconductor layer 10A.

For example, the first electrode layer 1C/1F includes a 100-nm-thick PEDOT-PSS (a conductive polymer made by H. C. Starck GmbH) layer 1C and a 40-nm-thick PEDOT-PSS (a conductive polymer made by H. C. Starck GmbH) layer 1F.

In this respect, the layer IF is formed to include a visible light absorbing material. For example, the layer IF is formed to contain silicon microparticles (nanosilicon) as the visible light absorbing material.

It should be noted that the silicon microparticles have a characteristic that "a bandgap between a conduction band and a valence band varies depending on the grain size of the silicon microparticles." For example, when the grain size is "5 nm," the bandgap is "2.0 eV." When the grain size is "3 nm," the bandgap is "2.5 eV."

Accordingly, a range of wavelengths (light energy) of the incident light which is absorbable into the layer 1 can be adjusted by changing the grain size of the silicon microparticles as the visible light absorbing material to be included in the layer 1.

The solar cell 10 is formed in a way that: once the incident light hits the semiconductor layer 10A via the front electrode layer 10B and the first electrode layer 10C, electrons in a valence band jump to a conduction band in the semiconductor layer 10A, and photocarriers (electrons and holes) are thereby generated; photocarrier separation occurs due to built-in potential difference (diffusion potential difference) which exists in the semiconductor layer 10A near the Schottky junction interface; and thereby photovoltaic effects take place.

Likewise, the solar cell 1 is formed in a way that: once the incident light hits the silicon microparticles in the layer 1C via the front electrode layer 10B and the first electrode layer 10C, electrons in a valence band jump to a conduction band in the silicon microparticles, and photocarriers (electrons and holes) are thereby generated; photocarrier separation occurs due to built-in potential difference (diffusion potential difference) which exists in the semiconductor layer 10A near the Schottky junction interface; and thereby photovoltaic effects take place.

In this respect, it is desirable that the silicon microparticles be subjected to a termination treatment. In this formation, the termination treatment improves the solubility of the silicon microparticles to the PEDOT-PSS solution to a large extent, and accordingly makes it possible to form the PEDOT-PSS layer IF containing the silicon microparticles with high homogeneity. Furthermore, in this formation, the termination treatment increases the stability in the atmosphere to a large extent, and accordingly makes it possible to extend the life of the solar cell 1 of the embodiment.

Referring to Fig. 2, descriptions will be hereinbelow provided for an example of the method of manufacturing the solar cell 1.

As shown in Fig. 2, a semiconductor substrate constituting the semiconductor layer 1A is cleaned in step S101.

For example, a ZnO substrate (zinc oxide single-crystal substrate) in (0001) orientation, made by Tokyo Denpa Co., Ltd., is subj ected to ultrasonic cleaning with ethanol for 10 minutes, and is then subjected to ultrasonic cleaning with acetone for 10 minutes. Subsequently, the ZnO substrate is subjected to a cleaning process using a UV ozone cleaner for 10 minutes.

In step S102, a first conductive polymer including the visible light absorbing material is applied to the ZnO substrate.

For example, a solution is prepared by mixing PEDOT-PSS, which is the conductive polymer made by H. C. Starck GmbH, and a toluene solution of decene-terminated nanosilicon in a proportion of 30 to 70 in mass percentage. This solution is applied to the aforementioned ZnO substrate by spin coating.

In step S103, a second conductive polymer is applied to a light-irradiated surface side of the first conductive polymer applied in step S102.

For example, PEDOT-PSS, which is the conductive polymer made by H. C. Starck GmbH, is applied to the light-irradiated surface side of the solution applied in the step S102 by spin coating. Here, a spinning condition is set to 5000 rpm per 30 seconds.

In step S104, a baking process is performed in atmosphere immediately after the completion of step S103. In this respect, a temperature profile is set, for example, to a sequence of 50°C (for 10 minutes), 80°C (for 10 minutes), 150°C (for 10 minutes), 190°C (for 10 minutes), and then slow cooling to normal temperature.

In step S105, the second electrode layer 1D and the back electrode layer 1E are formed on the opposite side of the semiconductor layer (ZnO substrate) from the light-irradiated surface. For example, the second electrode layer 1D and the back electrode layer 1E are formed by sputtering.

In step S106, the front electrode layer 1B is formed on a light-irradiated surface side of the second conductive polymer applied in step S103.

For example, after the completion of step S105, the ZnO substrate is taken out into atmosphere. Subsequently, a metal mask having a punched-out circular pattern with a diameter of 0.2 mm is attached onto the PEDOT-PSS applied in step S103, and the front electrode layer 1B is formed on the metal mask by sputtering.

Thereafter, the metal mask is removed, and the PEDOT-PSS with sides of approximately 0.3 mm around the front electrode layer 1B is mechanically removed using tweezers.

Since the first conductive polymer including the visible light absorbing material (for example, the PEDOT-PSS containing the nanosilicon) is not transparent to visible light, the solar cell 1 of the first embodiment of the present invention is capable of obtaining photovoltaic power using the visible light, and is capable of enhancing effects of power generation using the sunlight including a large amount of the visible light.

### (Experimental Examples)

Next, in order to make the effects of the present invention clearer, the photovoltaic power of the solar cell 10 of Comparative Example 1 and the photovoltaic power of the solar cell 1 of Example 1 were measured regarding cases of irradiation with LED lamps having a red wavelength (660 nm), a green wavelength (525 nm), a blue wavelength (470 nm) and an ultraviolet wavelength (365 nm), respectively.

It should be noted that the solar cell 1 used in Example 1 had the structure shown in Fig. 1 and was manufactured by the manufacturing method shown in Fig. 2. Meanwhile, the solar cell 10 of the conventional example 1 had the structure shown in Fig. 3 and was manufactured by the manufacturing method shown in Fig. 2 except the processing in step S102.

Here, Table 1 shows the photovoltaic power obtained from the experiment.

**[Table 1]**

| | Dark State | Red | Green | Blue | Ultraviolet |
|---|---|---|---|---|---|
| Comparative Example 1 | 0.00 V | 0.00 V | 0.00 V | 0.02 V | 0.45 V |
| Example 1 | 0.00 V | 0.01 V | 0.05 V | 0.20 V | 0.35 V |

As shown in Table 1, it is learned that the solar cell 1 of Example 1 using the conductive polymer including the visible light absorbing material is capable of obtain photovoltaic power from the visible light.

Hereinabove, the present invention has been described in detail by use of the foregoing embodiments. However, it is apparent to those skilled in the art that the present invention should not be limited to the embodiments described in the specification. The present invention can be implemented as an altered or modified embodiment without departing from the spirit and scope of the present invention, which are determined by the description of the scope of claims. Therefore, the description of the specification is intended for illustrative explanation only and does not impose any limited interpretation on the present invention.

Note that the entire content of Japanese Patent Application No. 2011-268787 (filed on December 8, 2011) is incorporated by reference in the present specification.

### [Industrial Applicability]

As described above, the solar cell and the method of manufacturing the same of the present invention are useful since they are capable of enhancing power generation efficiency with the sunlight including a large amount of the visible light.

## Claims

1. A solar cell comprising a first electrode layer, a semiconductor layer and a second electrode layer which are stacked, wherein
the first electrode layer is placed on a light-irradiated surface side of the semiconductor layer,
the first electrode layer and the semiconductor layer are joined together with a Schottky junction interface in between,
the second electrode layer is placed on an opposite side of the semiconductor layer from the light-irradiated surface,
the second electrode layer and the semiconductor layer are joined together in ohmic contact with each other, and
the first electrode layer includes a visible light absorbing material.

2. The solar cell of claim 1, wherein the visible light absorbing material is silicon microparticles.

3. The solar cell of claim 2, wherein the silicon microparticles are subjected to a termination treatment.

4. The solar cell of claim 1, wherein the first electrode layer is formed from a conductive polymer.

5. A method of manufacturing a solar cell, comprising the steps of:
applying a first conductive polymer including a visible light absorbing material to a light-irradiated surface side of a semiconductor layer;
applying a second conductive polymer to a light-irradiated surface side of the first conductive polymer; and
forming an electrode layer on an opposite side of the semiconductor layer from the light-irradiated surface.
